(19) Europäisches Patentamt / European Patent Office / Office européen des brevets

(11) **EP 2 469 641 B1**

(12) **EUROPEAN PATENT SPECIFICATION**

(45) Date of publication and mention
of the grant of the patent:
**23.07.2014 Bulletin 2014/30**

(21) Application number: **09848496.7**

(22) Date of filing: **20.08.2009**

(51) Int Cl.:
*H01G 9/20* (2006.01)     *H01M 14/00* (2006.01)
*C22C 38/00* (2006.01)     *C22C 38/54* (2006.01)
*C23F 1/28* (2006.01)      *C25F 3/06* (2006.01)
*H01L 31/04* (2014.01)

(86) International application number:
**PCT/JP2009/064597**

(87) International publication number:
**WO 2011/021299 (24.02.2011 Gazette 2011/08)**

(54) **DYE-SENSITIZED SOLAR CELL AND METHOD FOR MANUFACTURING THE SAME**

FARBSTOFFSENSIBILISIERTE SOLARZELLE UND HERSTELLUNGSVERFAHREN DAFÜR

CELLULE SOLAIRE SENSIBILISÉE PAR COLORANT ET SON PROCÉDÉ DE FABRICATION

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**27.06.2012 Bulletin 2012/26**

(73) Proprietor: **Nisshin Steel Co., Ltd.
Chiyoda-ku, Tokyo 100-8366 (JP)**

(72) Inventors:
• **NISHIDA Yoshikatu
Sakai-shi
Osaka 592-8332 (JP)**
• **FUJII Takahiro
Sakai-shi
Osaka 592-8332 (JP)**

(74) Representative: **Wagner, Karl H. et al
Wagner & Geyer
Gewürzmühlstrasse 5
80538 München (DE)**

(56) References cited:
**JP-A- 2005 285 472     JP-A- 2009 026 532
JP-A- 2009 200 008**

**Description**

TECHNICAL FIELD

The present invention relates to a dye-sensitized solar cell in which stainless steel is used as the constitutive material of the photoelectrode (negative electrode), and to its production method.

BACKGROUND ART

The mainstream of solar cells is toward those in which silicon is used as the photoelectric conversion element; however, as more economical next-generation solar cells in lieu of those, practical use of "dye-sensitized solar cells" is now under study. The dye-sensitized solar cell must be so designed that external light could reach the sensitizing dye carried inside the "photoelectrode" (inside the cell) therein, and therefore, the electroconductive member of the electrode to be on the incident light side must be formed of a light-transmissive electroconductive material. On the other hand, the material to constitute the electrode on the side opposite to the incident light side does not necessarily have to be light-transmissive, for which, therefore, use of a metal material of good electroconductivity is advantageous. Recently, as the metal material of the type, applicability of stainless steel that is a relatively inexpensive corrosion-resistant material has been confirmed, and accordingly, cost reduction of dye-sensitized solar cells is expected. JP 2008 34 110 A for example discloses a dye-sensitized solar cell in which a stainless steel plate is used as the electrode on the side opposite to the incident light side therein.

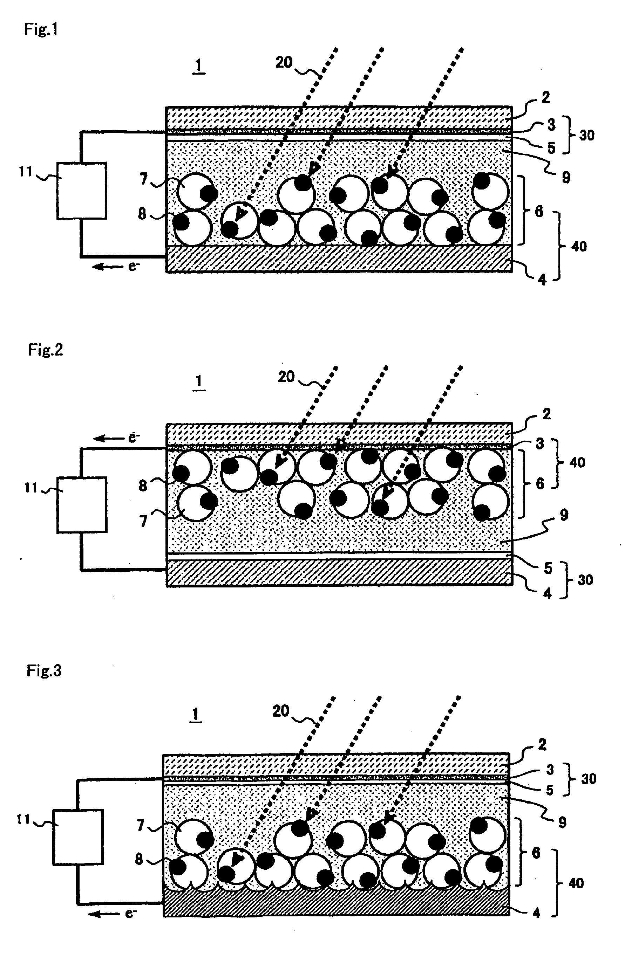

Fig. 1 and Fig. 2 each schematically show the configuration of an existing dye-sensitized solar cell in which a stainless steel plate is used as the electrode. Fig. 1 is a type in which the electrode on the incident light side is a "counter electrode" for transmitting electrons to the ions in the solution; and Fig. 2 is a type in which the electrode on the incident light side is a "photoelectrode" having a semiconductor layer (photoelectric conversion layer).

In the type of Fig. 1, the light-transmissive electroconductive material 3 formed on the surface of the light-transmissive substrate 2 faces the stainless steel plate 4 to constitute the dye-sensitized solar cell 1.

A semiconductor layer 6 is formed on the surface of the stainless steel plate 4. The semiconductor layer 6 is, for example, a porous layer formed by sintering oxide semiconductor particles of $TiO_2$ particles or the like having a large specific surface area, and the surface of the oxide semiconductor 7 carries a sensitizing dye 8 of ruthenium complex dye or the like. In this case, the stainless steel plate 4 and the semiconductor layer 6 existing on the surface thereof constitute the photoelectrode 40. The semiconductor layer 6 in the drawing conceptually shows the configuration of the oxide semiconductor 7 and the sensitizing dye 8 for convenience sake for illustration, and does not reflect directly the actual configuration of the semiconductor layer 6 (the same shall apply also to Fig. 2 and Fig. 3). On the other hand, as the light-transmissive substrate 2, used is a glass plate, a PEN (polyethylene naphthalate) film or the like. The light-transmissive electroconductive material 3 is generally formed of a light-transmissive electroconductive film of ITO (indium-tin oxide), FTO (fluorine-doped tin oxide), TO (tin oxide) or the like. On the surface of the light-transmissive electroconductive material 3, formed is a catalyst thin-film layer 5 of platinum or the like. In this case, the light-transmissive electroconductive material 3 and the catalyst thin-film layer 5 existing on the surface thereof constitute the counter electrode 30. The space between the catalyst thin-film layer 5 of the counter electrode 30 and the semiconductor layer 6 of the photoelectrode 40 is filled with an electrolytic solution 9 containing, for example, an iodide ion. Outside the dye-sensitized solar cell 1, a load 11 is connected to the counter electrode 30 and the photoelectrode 40 via a conductive wire, thereby forming a circuit.

With reference to an example where the oxide semiconductor 7 is $TiO_2$, the sensitizing dye 8 is a ruthenium complex dye, and the electrolytic solution 9 is a solution containing an iodide ion, the principle of cell operation is described briefly. When the incident light 20 has reached the sensitizing dye (ruthenium complex dye) 8, the sensitizing dye 8 absorbs the light and is excited, and the electron thereof is injected into the oxide semiconductor $(TiO_2)$ 7. The sensitizing dye (ruthenium complex dye) 8 in the excited state receives the electron from the iodide ion $I^-$ in the electrolytic solution 9, and is restored to the ground state. $I^-$ is oxidized to be $I_3^-$, and diffuses toward the catalyst thin-film layer 5 of the counter electrode 30, then receives the electron from the side of the counter electrode 30, and is restored to $I^-$. Accordingly, the electron moves in the route of sensitizing dye (ruthenium complex dye) 8 → oxide semiconductor $(TiO_2)$ 7 → stainless steel plate 4 → load 11 → light-transmissive electroconductive material 3 → catalyst thin-film layer 5 → electrolytic solution 9 → sensitizing dye (ruthenium complex dye) 8. As a result, a current to put the load 11 in action is generated.

In the type of Fig. 2, a stainless steel plate 4 is used as the counter electrode 30, and a light-transmissive electroconductive material 3 of ITO, FTO, TO or the like is used as the photoelectrode 40. The principle of current generation is basically the same as in the type of Fig. 1. In this case, the electron moves in the route of sensitizing dye (ruthenium complex dye) 8 → oxide semiconductor $(TiO_2)$ 7 → light-transmissive electroconductive material 3 → load 11 → stainless steel plate 4 → catalyst thin-film layer 5 → electrolytic solution 9 → sensitizing dye (ruthenium complex dye) 8. As a result, a current to put the load 11 in action is generated. Further, reference is made to JP 2009 026 532 A, which discloses a dye sensitized solar cell having a substrate of a stainless steel having a ferrite or austenite phase, a nanoporous dye sensitized metal oxide layer and a counter electrode.

SUMMARY OF THE INVENTION

PROBLEMS THAT THE INVENTION IS TO SOLVE

In the dye-sensitized solar cell of the type of Fig. 1 and Fig. 2, a stainless steel plate is used in one electrode to thereby realize cost reduction and electroconductivity enhancement. However, for further popularization of dye-sensitized solar cells, it is desired to further enhance the photoelectric conversion efficiency of the cells. To satisfy the requirement, the present invention provides a technique of enhancing the photoelectric conversion efficiency of the dye-sensitized solar cell in which a stainless steel is used in one electrode.

MEANS FOR SOLVING THE PROBLEMS

The photoelectrode of a dye-sensitized solar cell has a semiconductor layer as so mentioned above. In general, the semiconductor layer is formed on an electroconductive substrate, and a current is taken out through the substrate. In the type of Fig. 1, the stainless steel plate 4, and in the type of Fig. 2, the light-transmissive electroconductive material 3 each correspond to the above-mentioned electroconductive substrate. The present inventors have variously investigated and, as a result, have found that the adhesiveness between the semiconductor layer and the electroconductive substrate has a significant influence on the photoelectric conversion efficiency. When the adhesiveness between the semiconductor layer and the electroconductive substrate is increased, then the electric resistance at the joint part between the two decreases, which may contribute toward enhancing the photoelectric conversion efficiency. The present inventors have investigated in detail the cell configuration and, as a result, have found that, in the type of Fig. 1, when a surface-roughened stainless steel plate having a specific surface profile is applied to the stainless steel plate 4 constituting the photoelectrode 40, then the adhesiveness between the semiconductor layer 6 and the stainless steel plate 4 is increased and the photoelectric conversion efficiency can be thereby enhanced more than before.

JP 2008 34 110 A teaches that, as the stainless steel to be applied to the electrode material of a dye-sensitized solar cell, a type of steel having a Cr content of at least 17% by mass and an Mo content of at least 0.8% by mass should be selected. Afterwards, however, the present inventors have repeatedly investigated the cell taking the practicability thereof into consideration, and have found that a stainless steel having a Cr content of at least 16% by mass and an Mo content of at least 0.3% by mass is applicable to the electrode material of a dye-sensitized solar cell.

On the basis of these findings, the inventors have completed the present invention.

Specifically, in the invention, there is provided a dye-sensitized solar cell comprising a photoelectrode formed by using a stainless steel plate and a counter electrode formed by using a light-transmissive electroconductive material, wherein:

the photoelectrode comprises, as the substrate thereof, a stainless steel plate of a type of stainless steel having a chemical composition of any of the following (A) to (D) and having a roughened surface in which pit-like indentations are formed and which is controlled to have an arithmetic average roughness Ra of at least 0.2 μm, and comprises, as formed on the roughened surface of the substrate, a sensitizing dye-carrying semiconductor layer;
the counter electrode has a catalyst thin-film layer formed on the surface of the light-transmissive electroconductive material and has visible light transmissiveness; and
the semiconductor layer of the photoelectrode and the catalyst thin-film layer of the counter electrode face each other via an electrolytic solution.

[Type of stainless steel]

(A) One corresponding to a ferritic stainless steel containing Cr: at least 16% by mass and Mo: at least 0.3% by mass and defined by JIS G4305:2005.
(B) One corresponding to an austenitic stainless steel containing Cr: at least 16% by mass and Mo: at least 0.3% by mass and defined by JIS G4305:2005.
(C) A ferritic stainless steel comprising, by mass, C: at most 0.15%, Si: at most 1.2%, Mn: at most 1.2%, P: at most 0.04%, S: at most 0.03%, Ni: at most 0.6%, Cr: from 16 to 32%, Mo: from 0.3 to 3%, Cu: from 0 to 1%, Nb: from 0 to 1%, Ti: from 0 to 1%, Al: from 0 to 0.2%, N: at most 0.025%, B: from 0 to 0.01%, with a balance of Fe and inevitable impurities.

(D) An austenitic stainless steel comprising, by mass, C: at most 0.15%, Si: at most 4%, Mn: at most 2.5%, P: at most 0.045%, S: at most 0.03%, Ni: from 6 to 28%, Cr: from 16 to 32%, Mo: from 0.3 to 7%, Cu: from 0 to 3.5%, Nb: from 0 to 1%, Ti: from 0 to 1%, A1: from 0 to 0.1%, N: at most 0.3%, B: from 0 to 0.01%, with a balance of Fe and inevitable impurities.

In the above-mentioned dye-sensitized solar cell, the counter electrode is especially preferably one having visible light transmissiveness of such that the light transmittance at a wavelength of 500 nm is at least 55%. As the catalyst to constitute the catalyst thin-film layer of the counter electrode, there may be mentioned platinum, nickel or an electroconductive polymer. In case where the catalyst is platinum or nickel, preferably, the thickness of the catalyst thin-film layer is from 0.5 to 5 nm. In case where the catalyst is an electroconductive polymer, preferably, the thickness of the catalyst thin-film layer is from 1 to 10 nm.

The roughened surface of the substrate stainless steel plate for use in the photoelectrode is especially preferably such that the part thereof at which the neighboring indentations join together has an edged boundary.

In the invention, there is also provided a method for producing the above-mentioned dye-sensitized solar cell, including:

a step of etching a stainless steel plate in an aqueous solution with a ferric ion existing therein to form pit-like indentations in the plate, thereby giving a substrate that has a roughened surface with an arithmetic average roughness Ra of at least 0.2 $\mu$m,

a step of forming, on the roughened surface, a coating film that contains oxide semiconductor particles,

a step of firing the coating film to form a porous semiconductor layer,

a step of dipping the semiconductor layer in a solvent with a sensitizing dye dispersed therein to make the semiconductor layer carry the sensitizing dye, thereby giving a photoelectrode that comprises the sensitizing dye-carrying semiconductor layer on the roughened surface of the substrate stainless steel plate, and

a step of arranging the photoelectrode and the visible light-transmissive counter electrode with the catalyst thin-film layer formed on the surface of the light-transmissive electroconductive material, in such a manner that the semiconductor layer of the photoelectrode could face the catalyst thin-film layer of the counter electrode, and introducing an electrolytic solution into the space between the two electrodes.

The aqueous solution with a ferric ion existing therein is, for example, an aqueous, ferric chloride-containing solution.

ADVANTAGE OF THE INVENTION

According to the invention, it has become possible to enhance the photoelectric conversion efficiency more than before in a dye-sensitized solar cell that uses a stainless steel plate in the electrode on one side thereof. In the dye-sensitized solar cell of the invention, a type of stainless steel in which the Cr content and the Mo content are smaller than before can be used in the electrode, and therefore the applicability of the invention is expected to the field where use of a more inexpensive type of steel is desired.

BRIEF DESCRIPTION OF THE DRAWINGS

[Fig. 1] A view schematically showing the configuration of an existing dye-sensitized solar cell where a stainless steel plate is used in the photoelectrode.

[Fig. 2] A view schematically showing the configuration of an existing dye-sensitized solar cell where a stainless steel plate is used in the counter electrode.

[Fig. 3] A view schematically showing the configuration of the dye-sensitized solar cell of the invention.

[Fig. 4] A view schematically illustrating the cross-section structure of a roughened surface in which the boundary between the neighboring indentations has a gentle slope.

[Fig. 5] A view schematically illustrating the cross-section structure of a roughened surface where the part at which the neighboring indentations join together has an edged boundary.

[Fig. 6] One example of a SEM photograph of the roughened surface of a stainless steel plate in which pit-like indentations are formed by etching in an aqueous, ferric ion-containing solution.

MODE FOR CARRYING OUT THE INVENTION

Fig. 3 schematically shows the configuration of the dye-sensitized solar cell of the invention. The basic configuration of the cell and the current generation principle are the same as in Fig. 1. However, the cell significantly differs in that the stainless steel plate 4 constituting the photoelectrode 40 has a roughened surface 10 on which the semiconductor layer 6 exists.

[Roughened Surface Profile of Stainless Steel Plate]

In the invention, a stainless steel plate of which the surface is roughened by forming pit-like indentations therein is used as the electroconductive substrate (a member to carry a semiconductor layer thereon and to act for electric current passage) of the photoelectrode. The pit-like indentations are those formed by chemical etching in an aqueous electrolytic solution to thereby form "pitting corrosion" a type of local corrosion, on the surface of the stainless steel plate. The surface that has been roughened by forming a large number of pit-like indentations therein exhibits an anchor effect for the semiconductor layer existing thereon, and contributes toward enhancing the adhesiveness between the stainless steel plate and the semiconductor layer. Accordingly, the bonding force between the two is increased and the contact area is also increased, and as a result, the electric resistance in the bonding interface between the two is thereby reduced. As a result of various investigations, an increase in the photoelectric conversion efficiency is clearly recognized in the case of using a stainless steel plate of which the roughened surface with pit-like indentations formed therein has an arithmetic average roughness Ra of at least 0.2 $\mu$m. In case where Ra is smaller than the range, the above-mentioned effect would be insufficient and it would be difficult to significantly and stably increase the photoelectric conversion efficiency. The pit-like indentations can be formed by etching in an aqueous electrolytic solution containing a ferric ion, as described below; however, even though the etching is promoted too much, the pitting corrosion may grow in the plate thickness direction (depth direction) and the boundary between the neighboring indentations may disappear in the plate thickness direction while the thickness thereof is reduced, and therefore, Ra does not increase indefinitely. Accordingly, it is unnecessary to define the uppermost limit of Ra, but in fact, the range of Ra may be from about 0.2 to 5 $\mu$m or so for readily attaining the photoelectric conversion efficiency-enhancing effect.

The areal ratio in percentage of the pit-like indentations-formed part to the surface of the stainless steel plate is preferably at least 20% in terms of the projected areal ratio in percentage in the view of the roughened surface from directly above. The pit-like indentations may be formed in the entire surface of the steel plate, and the areal ratio of the pit-like indentations-formed part may be 100%.

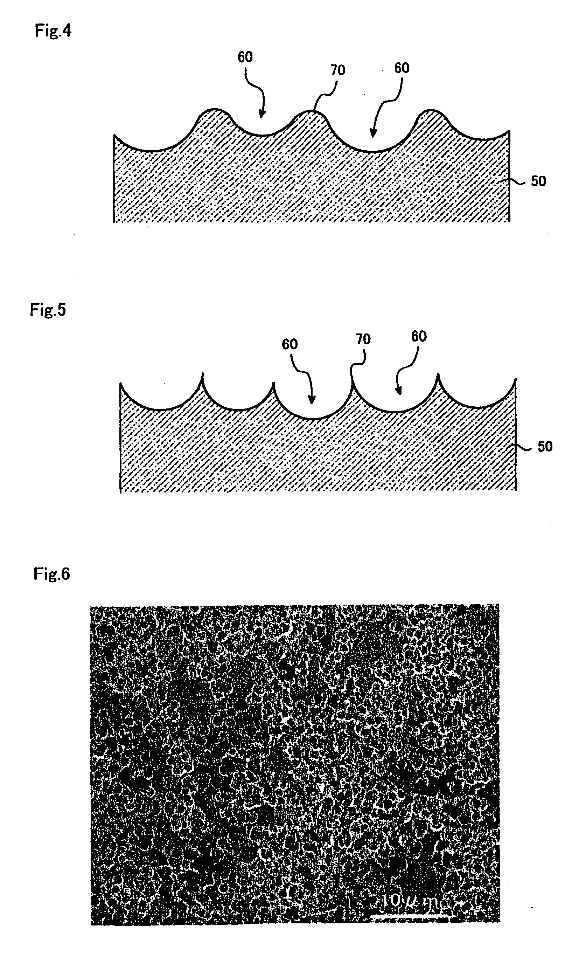

Fig. 4 schematically illustrates the cross-section structure of a roughened surface in which the boundary between the neighboring indentations has a gentle slope. Indentations 60 are formed in the surface of the stainless steel plate 50, but the indentation boundary 70 has a gentle slope. The roughened surface profile of the type may be often formed when a stainless steel plate is etched in an aqueous electrolytic solution with no ferric ion therein, or when a stainless steel plate is surface-roughened by a physical removing means of polishing, shot blasting or the like. In case where the indentation boundary 70 is excessively gentle, the anchor effect for the semiconductor layer would reduce and the effect of enhancing the adhesiveness may be insufficient. In such a case, the effect of enhancing the photoelectric conversion efficiency may also be poor.

Fig. 5 schematically illustrates the cross-section structure of a roughened surface where the part at which the neighboring indentations join together has an edged boundary. This roughened surface profile is favorable for the stainless steel plate to be applied to the present invention. Indentations 60 are formed in the surface of the stainless steel plate 50, and the indentations are pit-like indentations. In the process where pitting corrosion grows in the depth direction, the opening diameter of the corrosion pit increases little by little, and the walls of the neighboring indentations 60 come to join together whereby the indentation boundary 70 becomes an edged boundary. The roughened surface profile of the type is attained by etching in an aqueous electrolytic solution with a ferric ion existing therein. The presence of the edged boundary brings about an excellent anchor effect for the semiconductor layer, and the adhesiveness between the stainless steel plate and the semiconductor layer is thereby enhanced. As a result, the electric resistance at the joint part between the stainless steel plate and the semiconductor layer is reduced, and the photoelectric conversion efficiency is thereby significantly enhanced.

Fig. 6 shows one example of a SEM photograph of the roughened surface of a surface-roughened stainless steel plate applicable to the dye-sensitized solar cell of the invention. An edged boundary is observed between the neighboring pit-like indentations.

[Chemical Composition of Stainless Steel Plate]

As the stainless steel plate to be applied to the electroconductive substrate of the photoelectrode in the invention, a type of stainless steel that has excellent resistance to the electrolytic solution in the dye-sensitized solar cell must be employed. As a result of detailed investigations made by the present inventors, it has been found that when a type of stainless steel containing Cr in an amount of at least 16% by mass and Mo in an amount of at least 0.3% by mass is used, a practicable dye-sensitized solar cell can be constructed.

In general, stainless steel is said to be poor in corrosion resistance to an aqueous solution containing a chloride ion $Cl^-$, and for enhancing the corrosion resistance, increase in Cr and addition of Mo are said to be effective. For example, ferritic SUS444 suitable to water heaters secures a Cr content of at least 17% by mass and an Mo content of at least 1.75% by mass; and even SUS316, a highly corrosion-resistant, general-purpose austenitic steel secures a Cr content of at least 16% by mass and an Mo content of at least 2% by mass. However, there are known few reports relating to the corrosion resistance of stainless steel to iodide ion, and in particular, any substantial investigation relating to the use for photoelectrodes in dye-sensitized solar cells is not as yet made sufficiently. Given the situation, the present inventors have made detailed investigations and have known that a dye-sensitized solar cell, which is so designed that the change of the photoelectric conversion efficiency $\eta_1$ (%) of the cell thereof, as measured after left at 65°C for 100 hours, relative to the initial photoelectric conversion efficiency $\eta_0$ (%), as measured immediately after its construction, (conversion efficiency retention to be represented by the following formula (2)) could be at least 80%, can be evaluated to have practical-level durability in applications where the cell is incorporated in everyday-application products for personal use. Preferably, the conversion efficiency retention is at least 90%, more preferably at least 95%. After further investigations made by the inventors, it has been clarified that, when a type of stainless steel containing Cr in an amount of at least 16% by mass and Mo in an amount of at least 0.3% by mass is employed, then a dye-sensitized solar cell having a conversion efficiency retention of at least 80% can be constructed sufficiently.

Concretely, the above-mentioned types of stainless steel (A) to (D) are mentioned to be preferred ones for use herein. For further better corrosion resistance, the Cr content is preferably at least 17% by mass. The Mo content is preferably at least 0.5% by mass, and may be controlled to fall within a range of at least 0.8% by mass, or at least 1.0% by mass. The uppermost limit of Cr may be 32% by mass, and may be controlled to fall within a component range of at most 25% by mass. The uppermost limit of Mo may be 3% by mass, and may be controlled to fall within a component range of at most 2% by mass.

[Surface Roughening Treatment of Stainless Steel Plate]

The specific roughened surface profile mentioned as above can be formed by etching a stainless steel plate of which the surface is not roughened, for example, an ordinary annealed/acid-pickled steel, a BA-annealed steel, a skin-pass finished steel or the like, in an aqueous solution with a ferric ion existing therein. For the etching, for example, employable is a method of dipping and soaking in a liquid, a method of alternating electrolysis in a liquid or the like. In any case, ferric chloride ($FeCl_3$) is favorably used as the ferric ion source.

In the case of dipping and soaking, a method of etching in a mixed aqueous solution of ferric chloride ($FeCl_3$) and hydrochloric acid (HCl) is extremely effective. Concretely, for example, within a condition range where the $Fe^{3+}$ ion concentration is from 15 to 100 g/L, the HC1 concentration is from 20 to 200 g/L, the temperature is from 35 to 70°C and the dipping time is from 3 to 120 seconds, a condition to give a roughened surface having pit-like indentations and having Ra of at least 0.2 $\mu$m can be found out.

In the case of alternating electrolysis, for example, an aqueous solution of ferric chloride is used as the electrolytic solution, and within a condition range where the $Fe^{3+}$ ion concentration is from 1 to 50 g/L, the temperature is from 30 to 70°C, the anode electrolytic current density is from 1.0 to 10.0 kA/m$^2$, the cathode electrolytic current density is from 0.1 to 3.0 kA/m$^2$, an alternating electrolysis cycle is from 1 to 20 Hz and an electrolysis time is from 10 to 300 seconds, a condition to give a roughened surface having pit-like indentations and having Ra of at least 0.2 $\mu$m can be found out. When the alternating electrolysis cycle is reduced, then the power-on time in one cycle may be long and the size of the pit-like indentations can be thereby enlarged; but on the contrary, when the alternating electrolysis cycle is prolonged, then the size of the pit-like indentations can be reduced.

[Production of Photoelectrode]

The photoelectrode can be produced, for example, according to the method mentioned below. First, a coating material (paste or liquid) containing oxide semiconductor particles is applied on the roughened surface of the above-mentioned, surface-roughened stainless steel plate, and dried to form a coating film thereon. Subsequently, the coating film is fired to sinter the oxide particles, thereby forming a porous semiconductor layer. For the firing, the coated stainless steel plate is put in a heating furnace and is kept therein at a temperature at which the particles could be sintered suitably (for example, at 400 to 600°C). As the oxide semiconductor, $TiO_2$ is generally used, but ZnO, $SnO_2$, $ZrO_2$ or the like may also be used. These oxides may be combined and used here. Thus formed, the porous semiconductor layer is dipped in an organic solvent with a sensitizing dye dispersed therein, thereby making the semiconductor layer carry the sensitizing dye. The coated stainless steel plate may be dipped in the organic solvent. As the sensitizing dye, typically used here is ruthenium complex dye.

[Production of Counter Electrode]

The counter electrode may be produced by making a light-transmissive electroconductive material held on the surface of a light-transmissive substrate such as a glass plate, a PEN (polyethylene naphthalate) film or the like followed by forming a catalyst thin-film layer on the surface of the light-transmissive electroconductive material. As the light-transmissive electroconductive material, herein usable is an electroconductive film of ITO (indium-tin oxide), FTO (fluorine-doped tin oxide), TO (tin oxide) or the like. As the catalyst thin-film layer, preferred for use herein is a metal film of platinum, nickel or the like, or an electroconductive polymer film of polyaniline, polyethylenedioxythiophene or the like. The metal film may be formed, for example, according to a sputtering method. The electroconductive polymer film may be formed, for example, according to a spin coating method. Especially preferably, the counter electrode has visible light transmissiveness of such that the light transmittance at a wavelength of 500 nm is at least 55%. In this case, a high photoelectric conversion efficiency can be obtained. The light transmittance varies depending on the thickness of the catalyst thin-film layer. A thinner catalyst thin-film layer may have a higher transmittance. However, when the catalyst thin-film layer is thinned too much, the photoelectric conversion efficiency may lower owing to the reduction in the catalytic effect. As a result of various investigations made by the inventors, it has been found that, in case where the catalyst is platinum or nickel, preferably, the thickness of the catalyst thin-film layer is controlled to fall within a range of from 0.5 to 5 nm. In case where the catalyst is polyaniline, preferably, the thickness of the catalyst thin-film layer is controlled to fall within a range of from 1 to 10 nm.

[Construction of Cell]

The above-mentioned photoelectrode and counter electrode are so arranged that the semiconductor layer of the photoelectrode could face the catalyst thin-film layer of the counter electrode via an electrolytic solution put therebetween, thereby constructing the dye-sensitized solar cell of the present invention.

EXAMPLE 1

A stainless steel ingot having the composition shown in Table 1 was produced, and worked into a cold-rolled annealed steel plate having a thickness of 0.2 mm (No. 2D finish) according to an ordinary stainless steel plate production process. In the column of morphology in Table 1, "$\alpha$" means a ferritic type, and "$\gamma$" means an austenitic type. In the Table, "-" (hyphen) means lower than the detectable limit in ordinary analysis in steel production sites.
[Table 1]

Table 1

| Group | Steel | Chemical Composition (% by mass) | | | | | | | | | | | | Morphology |
|---|---|---|---|---|---|---|---|---|---|---|---|---|---|---|
| | | C | Si | Mn | P | S | Ni | Cr | Mo | Cu | Nb | Ti | Al | |
| Comparative Steel | A | 0.069 | 0,51 | 0.34 | 0.032 | 0.005 | 0.14 | 16.13 | 0.11 | 0.04 | - | 0.004 | - | α |
| | B | 0.014 | 0.42 | 0.58 | 0.028 | 0.003 | 0.16 | 17.25 | 0.02 | 0.06 | 0.40 | - | 0.007 | |
| | C | 0.070 | 0.54 | 0.79 | 0.035 | 0.006 | 8.04 | 18.12 | 0.20 | 0.31 | - | - | - | γ |
| | D | 0.062 | 0.56 | 1.52 | 0.025 | 0.001 | 19.08 | 25.50 | 0.24 | 0.13 | 0.03 | - | 0.006 | |
| Steel for the Invention | E | 0.007 | 0.48 | 0.09 | 0.024 | 0.001 | 0.10 | 16.25 | 0.33 | 0.02 | 0.33 | 0.270 | 0.087 | α |
| | F | 0.003 | 0.09 | 0.09 | 0.032 | 0.001 | 0.10 | 17.52 | 0.87 | - | - | 0.180 | 0.071 | |
| | G | 0,006 | 0.20 | 0.13 | 0.030 | 0.001 | 0.11 | 22.14 | 1.12 | 0.02 | 0.20 | 0.204 | 0.074 | |
| | H | 0.017 | 0.53 | 1.74 | 0.027 | 0.002 | 12.58 | 17.22 | 2.73 | 0.34 | - | - | - | γ |

[Surface Roughening Treatment]

A sample cut out of the above-mentioned steel plate was surface-roughened by dipping and soaking or by alternating electrolysis, thereby preparing test samples. Some test samples that had not been surface-roughened to be as yet merely No. 2D finish were also prepared. In Table 2, those processed by dipping and soaking are represented by "dipping"; and those processed by alternating electrolysis are by "electrolysis".

The surface roughening treatment by dipping and soaking was attained according to a method of dipping the test piece in an aqueous mixed solution of ferric chloride + hydrochloric acid having an $Fe^{3+}$ ion concentration of 30 g/L and an HCl concentration of 30 g/L at a temperature of 50°C, for 40 seconds.

The surface roughening treatment by alternating electrolysis was attained in an aqueous ferric chloride solution having an $Fe^{3+}$ ion concentration of from 5 to 50 g/L at a temperature of from 35 to 65°C, under the condition where the anode electrolysis current density was 3 kA/m$^2$, the cathode electrolysis current density was 0.3 kA/m$^2$, the alternating electrolysis cycle was 10 Hz and the electrolysis time was from 10 to 120 seconds.

As a result of SEM observation, it was confirmed that the roughened surfaces obtained herein all had pit-like indentations in an areal ratio in percentage of at least 20%, and that the part at which the neighboring indentations joined together had an edged boundary.

[Measurement of Ra]

Using a microstructure analyzer (Kosaka Laboratory's Surfcorder ET4000A), the arithmetic average roughness Ra of the obtained roughened surface was measured.

[Production of Photoelectrode]

As the material for forming a semiconductor layer, prepared was a TiO$_2$ paste (Peccel Technologies' PECC-01-06). The TiO$_2$ paste was applied onto the surface of the above-mentioned sample (in case where the sample had been surface-roughened, the paste was applied onto the roughened surface thereof) according to a doctor blade method, and dried to thereby form a TiO$_2$-containing coating film thereon. Subsequently, the film-coated substrate, stainless steel plate was put into an oven at 450°C and fired therein, thereby sinter the TiO$_2$ particles to form a semiconductor layer. The mean thickness of the thus-formed semiconductor layer was 10 $\mu$m. As a sensitizing dye, ruthenium complex dye (Peccel Technologies' PECD-07) was used, and this was dispersed in a mixed solvent of acetonitrile and tert-butanol to prepare a dye dispersion. The above-mentioned, semiconductor layer-coated stainless steel plate was dipped in the dye dispersion, thereby producing a photoelectrode having the sensitizing dye carried by the semiconductor layer thereof.

[Production of Counter Electrode]

As the light-transmissive electroconductive material for a counter electrode, prepared was "ITO-PEN film" having an ITO film formed on a PEN film substrate (Peccel Technologies' PECF-IP). This was set in a sputtering apparatus, and a target of platinum was sputtered thereonto for 1 minute to form a platinum catalyst thin-film layer on the ITO film, thereby producing a counter electrode. In this case, the thickness of the platinum was about 3 nm.

[Production of Cell]

The above-mentioned photoelectrode and counter electrode were combined between a heat-sealable film (Peccel Technologies' Surlyn Film" as arranged therebetween to surround a part to be a cell, thereby producing a cell structure in which the distance between the stainless steel surface of the photoelectrode and the counter electrode was 50 $\mu$m. The cell structure was hot-compressed with a hot presser to seal up the cell, and further an epoxy resin was applied to the periphery of the cell and cured therearound. Via the electrolytic solution introducing mouth formed in the counter electrode, an electrolytic solution (Peccel Technologies' PECE-K01) was injected into the cell with a microsyringe. Subsequently, the electrolytic solution introducing mouth was sealed up with an epoxy resin, thereby constructing a dye-sensitized solar cell.

[Measurement of Photoelectric Conversion Efficiency]

The conversion efficiency of the thus-constructed, dye-sensitized solar cell was measured according to the process mentioned below.

Using a solar simulator (Yamashita Denso's YSS-100), the dye-sensitized solar cell was tested for the I-V characteristic thereof by the use of a source meter, Keithley's 2400 Model, while irradiated with pseudo-sunlight at AM 1.5 and at 100 mW/cm$^2$ from the side of the counter electrode thereof, from which the short-circuit current JSC, the open voltage VOC and the form factor FF were obtained. From these values, the photoelectric conversion efficiency $\eta$ was

computed according to the following formula (1).

```
Photoelectric Conversion Efficiency η (%)

= short-circuit current JSC (mA/cm²) × open voltage VOC (V)

× fill factor FF/incident light 100 (mW/cm²) × 100 …(1)
```

The initial photoelectric conversion efficiency, as measured immediately after the cell construction, is represented by $\eta_0$ (%). After measurement of $\eta_0$ (%), the solar cell was left in a thermostat at 65°C for 100 hours. Subsequently, the photoelectric conversion efficiency of the cell was measured in the same manner as above. The photoelectric conversion efficiency, as measured after left at 65°C for 100 hours, is represented by $\eta_1$ (%). The degree of the change of the photoelectric conversion efficiency after left under the above-mentioned condition was evaluated by the conversion efficiency retention (%) defined by the following formula (2):

```
Conversion Efficiency Retention (%) = η₁/η₀ × 100 …(2)
```

The results are shown in Table 2.
[Table 2]

Table 2

| Group | Test No. | Test Sample | | | Cell Characteristics | | | | | | | | | Conversion Efficiency Retention (%) |
| | | Steel | Surface Roughening Treatment | Ra $(\mu m)$ | Initial Stage | | | | After Left at 65°C, 100 hours | | | | |
| | | | | | Jsc | Voc | FF | $\eta_0$ | Jsc | Voc | FF | $\eta 1$ | |
|---|---|---|---|---|---|---|---|---|---|---|---|---|---|
| Comparative Example | 1 | A | no | 0.09 | 9.0 | 0.72 | 0.60 | 3.89 | 4.0 | 0.63 | 0.20 | 0.50 | 13 |
| | 2 | A | dipping | 0.26 | 9.2 | 0.71 | 0.63 | 4.12 | 4.3 | 0.61 | 0.25 | 0.66 | 16 |
| | 3 | B | dipping | 0.30 | 9.3 | 0.70 | 0.64 | 4.17 | 5.9 | 0.62 | 0.30 | 1.10 | 26 |
| | 4 | C | electrolysis | 0.42 | 9.2 | 0.71 | 0.63 | 4.12 | 7.6 | 0.62 | 0.37 | 1.74 | 42 |
| | 5 | D | electrolysis | 0.57 | 9.3 | 0.70 | 0.63 | 4.10 | 7.7 | 0.63 | 0.40 | 1.94 | 47 |
| | 6 | E | no | 0.10 | 9.1 | 0.70 | 0.60 | 3.82 | 9.0 | 0.70 | 0.60 | 3.78 | 99 |
| | 7 | G | no | 0.12 | 9.0 | 0.70 | 0.60 | 3.78 | 8.9 | 0.70 | 0.60 | 3.74 | 99 |
| | 8 | H | no | 0.13 | 9.1 | 0.70 | 0.59 | 3.76 | 9.0 | 0.70 | 0.59 | 3.72 | 99 |
| Example at the Invention | 9 | E | dipping | 0.34 | 9.4 | 0.71 | 0.65 | 4.34 | 9.3 | 0.71 | 0.65 | 4.29 | 99 |
| | 10 | F | dipping | 0.21 | 9.5 | 0.71 | 0.65 | 4.38 | 9.5 | 0.71 | 0.65 | 4.38 | 100 |
| | 11 | G | electrolysis | 0.55 | 9.5 | 0.70 | 0.66 | 4.39 | 9.4 | 0.70 | 0.66 | 4.34 | 99 |
| | 12 | H | electrolysis | 0.43 | 9.3 | 0.70 | 0.64 | 4.17 | 9.2 | 0.70 | 0.64 | 4.12 | 99 |

EP 2 469 641 B1

As seen from Table 2, a surface-roughened stainless steel plate having a Cr content and a Mo content each falling within a suitable range, having pit-like indentations formed therein and having Ra of not less than 0.2 $\mu$m was used in the samples of the invention, and therefore, the photoelectric conversion efficiency $\eta_0$ and $\eta_1$ of the samples were both high and the conversion efficiency retention thereof was extremely high.

As opposed to these, a stainless steel plate having a low Mo content is used in Test Nos. 1 to 5 of comparative samples, and the photoelectric conversion efficiency after left at 65°C for 100 hours of the samples was extremely low and the conversion efficiency retention thereof was also low. This may be considered because the corrosion resistance of the steel plate in the electrolytic solution was poor and therefore Fe and Cr of the stainless steel ingredients dissolved out in the electrolytic solution. In Test Nos. 6 to 8, an un-roughened stainless steel plate was used and therefore, the adhesiveness between the stainless steel plate of the photoelectrode and the semiconductor layer would be low, and the photoelectric conversion efficiency $\eta_0$ and $\eta_1$ of the samples were both low.

EXAMPLE 2

As the photoelectrode, Test No. 11 (Steel G) in Table 2 produced according to the same method as in Example 1 was prepared.

The counter electrode was produced as follows: Platinum, nickel or polyaniline as the catalyst, and the thickness of the catalyst thin-film layer was changed variously as described below. Like in Example 1, an ITO film was formed on the PEN film substrate to prepare "ITO-PEN film". In case where platinum or nickel was employed, the catalyst thin-film layer was formed using a sputtering apparatus like in Example 1, and the film thickness was controlled by changing the sputtering time. In case where polyaniline was employed, polyaniline was dissolved in a solvent toluene, the resulting solution was dropwise applied onto the ITO film to thereby form a catalyst thin-film layer thereon according to a spin coating method, and by changing the rotation speed in spin coating, the film thickness was controlled. Thus formed, the counter electrode was analyzed for the light transmittance at a wavelength of 500 nm, using a spectrophotometer (Hitachi High Technologies' U-4100).

Using the photoelectrode and the counter electrode, a dye-sensitized solar cell was constructed according to the same method as in Example 1, and analyzed for the photoelectric conversion efficiency $\eta_0$. The results are shown in Table 3.

[Table 3]

Table 3

| Group | Test No | Counter Electrode | | | Cell Characteristics (initial stage) | | | |
|---|---|---|---|---|---|---|---|---|
| | | Type of Catalyst | Catalyst Thin-Film Layer (nm) | Light Transmittance at 500 nm (%) | Jsc | Voc | FF | $\eta 0$ |
| Comparative Example | 21 | platinum | 12 | 47 | 3.7 | 0.68 | 0.70 | 1.76 |
| | 22 | nickel | 12 | 47 | 3.5 | 0.64 | 0.51 | 1.14 |
| | 23 | polyaniline | 30 | 47 | 3.1 | 0.66 | 0.45 | 0.92 |
| Example of the Invention | 24 | platinum | 3 | 60 | 9.5 | 0.70 | 0.66 | 4.39 |
| | 25 | nickel | 3 | 60 | 8.7 | 0.68 | 0.45 | 2.66 |
| | 26 | polyaniline | 6 | 60 | 6.6 | 0.69 | 0.47 | 2.14 |
| | 27 | platinum | 1 | 73 | 8.4 | 0.69 | 0.68 | 3.94 |
| | 28 | nickel | 1 | 73 | 7.2 | 0.65 | 0.55 | 2.57 |
| | 29 | polyaniline | 3 | 73 | 6.0 | 0.65 | 0.50 | 1.95 |

As known from Table 3, it is important to increase the light transmittance of the counter electrode to be higher than a predetermined level, for realizing good photoelectric conversion efficiency.

DESCRIPTION OF REFERENCE NUMERALS

1    Dye-Sensitized Solar Cell
2    Light-Transmissive Substrate
3    Light-Transmissive Electroconductive Material

4       Stainless Steel Plate
5       Catalyst Thin-Film Layer
6       Semiconductor Layer
7       Oxide Semiconductor
8       Sensitizing Dye
9       Electrolytic Solution
10      Roughened Surface
11      Load
30      Counter Electrode
40      Photoelectrode
50      Stainless Steel Plate
60      Indentation
70      Indentation Boundary

**Claims**

1.  A dye-sensitized solar cell (1) comprising a photoelectrode (40) formed by using a stainless steel plate (4; 50) and a counter electrode (30) formed by using a light-transmissive electroconductive material (3), wherein:

    the photoelectrode (40) comprises, as the substrate thereof, a stainless steel plate (4; 50) having a chemical composition corresponding to a ferritic stainless steel containing Cr: at least 16% by mass and Mo: at least 0.3% by mass and defined by JIS G4305:2005, and comprises, as formed on the surface of the substrate, a sensitizing dye-carrying semiconductor layer (6);
    the counter electrode (30) has a catalyst thin-film layer (5) formed on the surface of the light-transmissive electroconductive material (3) and has visible light transmissiveness; and
    the semiconductor layer (6) of the photoelectrode (40) and the catalyst thin-film layer (5) of the counter electrode (30) face each other via an electrolytic solution (9);

    **characterized in that** said stainless steel plate (4; 50) has a roughened surface in which pit-like indentations (60) are formed and which is controlled to have an arithmetic average roughness Ra of at least 0.2 μm.

2.  The dye-sensitized solar cell (1) as claimed in claim 1, wherein the stainless steel for use in the photoelectrode (40) has a chemical composition corresponding to an austenitic stainless steel containing Cr: at least 16% by mass and Mo: at least 0.3% by mass and defined by JIS G4305:2005.

3.  The dye-sensitized solar cell (1) as claimed in claim 1, wherein the stainless steel for use in the photoelectrode (40) is a ferritic stainless steel comprising, by mass, C: at most 0.15%, Si: at most 1.2%, Mn: at most 1.2%, P: at most 0.04%, S: at most 0.03%, Ni: at most 0.6%, Cr: from 16 to 32%, Mo: from 0.3 to 3%, Cu: from 0 to 1%, Nb: from 0 to 1%, Ti: from 0 to 1%, Al: from 0 to 0.2%, N: at most 0.025%, B: from 0 to 0.01%, with a balance of Fe and inevitable impurities.

4.  The dye-sensitized solar cell (1) as claimed in claim 1, wherein the stainless steel for use in the photoelectrode (40) is an austenitic stainless steel comprising, by mass, C: at most 0.15%, Si: at most 4%, Mn: at most 2.5%, P: at most 0.045%, S: at most 0.03%, Ni: from 6 to 28%, Cr: from 16 to 32%, Mo: from 0.3 to 7%, Cu: from 0 to 3.5%, Nb: from 0 to 1%, Ti: from 0 to 1%, Al: from 0 to 0.1%, N: at most 0.3%, B: from 0 to 0.01%, with a balance of Fe and inevitable impurities.

5.  The dye-sensitized solar cell (1) as claimed in any of claims 1 to 4, wherein the counter electrode (30) has visible light transmissiveness of such that the light transmittance at a wavelength of 500 nm is at least 55%.

6.  The dye-sensitized solar cell (1) as claimed in any of claims 1 to 5, wherein the catalyst to constitute the catalyst thin-film layer (5) of the counter electrode (30) is platinum, nickel or an electroconductive polymer.

7.  The dye-sensitized solar cell (1) as claimed in claim 6, wherein the catalyst is platinum or nickel, and the thickness of the catalyst thin-film layer (5) is from 0.5 to 5 nm.

8.  The dye-sensitized solar cell (1) as claimed in claim 6, wherein the catalyst is an electroconductive polymer, and the thickness of the catalyst thin-film layer (5) is from 1 to 10 nm.

9. A method for producing a dye-sensitized solar cell (1) of any of claims 1 to 8, which comprises:

a step of etching a stainless steel plate (4; 50) in an aqueous solution with a ferric ion existing therein to form pit-like indentations (60) in the plate, thereby giving a substrate that has a roughened surface with an arithmetic average roughness Ra of at least 0.2 μm,

a step of forming, on the roughened surface, a coating film that contains oxide semiconductor particles,

a step of firing the coating film to form a porous semiconductor layer (6),

a step of dipping the semiconductor layer (6) in a solvent with a sensitizing dye (8) dispersed therein to make the semiconductor layer (6) carry the sensitizing dye (8), thereby giving a photoelectrode (40) that comprises the sensitizing dye-carrying semiconductor layer (6) on the roughened surface of the substrate stainless steel plate (4; 50), and

a step of arranging the photoelectrode (40) and the visible light-transmissive counter electrode (30) with the catalyst thin-film layer (5) formed on the surface of the light-transmissive electroconductive material, in such a manner that the semiconductor layer (6) of the photoelectrode (40) could face the catalyst thin-film layer (5) of the counter electrode (30), and introducing an electrolytic solution (9) into the space between the two electrodes (40, 30).

10. The method for producing a dye-sensitized solar cell (1) as claimed in claim 9, wherein the aqueous solution with a ferric ion existing therein is an aqueous, ferric chloride-containing solution.

## Patentansprüche

1. Farbstoffsensibilisierte Solarzelle (1), die eine Photoelektrode (40), die unter Verwendung einer rostfreien Stahlplatte (4; 50) gebildet ist, und eine Gegenelektrode (30) aufweist, die unter Verwendung eines lichtdurchlässigen, elektrisch leitenden Materials (3) gebildet ist, wobei:

die Photoelektrode (40) als ihr Substrat eine rostfreie Stahlplatte (4; 50) mit einer chemischen Zusammensetzung aufweist, die einem ferritischen, rostfreiem Stahl entspricht, der zumindest 16 Massenprozent Cr und mindestens 0,3 Massenprozent Mo enthält und durch JIS G4305:2005 definiert ist, und wenn sie auf der Oberfläche des Substrats gebildet ist, eine sensibilisierende farbstofftragende Halbleiterschicht (6) aufweist;

die Gegenelektrode (30) eine Katalysatordünnfilmschicht (5) aufweist, die auf der Oberfläche des lichtdurchlässigen, elektrisch leitenden Materials (3) gebildet ist und eine Durchlässigkeit für sichtbares Licht besitzt; und

die Halbleiterschicht (6) der Photoelektrode (40) und die Katalysatordünnfilmschicht (5) der Gegenelektrode (30) über eine elektrolytische Lösung (9) zueinander weisen;

**dadurch gekennzeichnet, dass** die rostfreie Stahlplatte (4; 50) eine aufgeraute Oberfläche besitzt, in der grübchenartige Vertiefungen (60) gebildet sind und die so gesteuert wird, dass sie eine arithmetische Durchschnittsrauigkeit Ra von zumindest 0,2 μm besitzt.

2. Farbstoffsensibilisierte Solarzelle (1) gemäß Anspruch 1, wobei der rostfreie Stahl zur Verwendung in der Photoelektrode (40) eine chemische Zusammensetzung aufweist, die einem austenitischen, rostfreien Stahl entspricht, der zumindest 16 Massenprozent Cr und zumindest 0,3 Massenprozent Mo enthält und durch JIS G4305:2005 definiert ist.

3. Farbstoffsensibilisierte Solarzelle (1) gemäß Anspruch 1, wobei der rostfreie Stahl zur Verwendung in der Photoelektrode (40) ein ferritischer, rostfreier Stahl ist, der nach Masse zumindest 0,15% C, maximal 1,2% Si, maximal 1,2% Mn, maximal 0,04% P, maximal 0,03% S, maximal 0,6% Cr, zwischen 16 bis 32% Mo, von 0,3 bis 3% Cu, von 0 bis 1% Nb, von 0 bis 1% Ti, von 0 bis 0,2% Al, maximal 0,025% N, 0 bis 0,01% B mit einem Abgleich von Fe und unvermeidbaren Verschmutzungen aufweist.

4. Farbstoffsensibilisierte Solarzelle (1) gemäß Anspruch 1, wobei der rostfreie Stahl zur Verwendung in der Photoelektrode (40) ein austenitischer, rostfreier Stahl ist, der nach Masse zumindest 0,15% C, maximal 4% Si, maximal 2,5% Mn, maximal 0,045% P, maximal 0,03% S, von 6 bis 28% Ni, von 16 bis 32% Cr, von 0,3 bis 7% Mo, von 0 bis 3,5% Cu, von 0 bis 1% Nb, von 0 bis 1% Ti, von 0 bis 0,1% Al, maximal 0,3% N, 0 bis 0,01% B mit einem Abgleich von Fe und unvermeidbaren Verschmutzungen aufweist.

5. Farbstoffsensibilisierte Solarzelle (1) gemäß einem der Ansprüche 1 bis 4, wobei die Gegenelektrode (30) eine Durchlässigkeit für sichtbares Licht derart aufweist, dass die Lichtdurchlässigkeit bei einer Wellenlänge von 500 nm mindestens 55% beträgt.

6. Farbstoffsensibilisierte Solarzelle (1) gemäß einem der Ansprüche 1 bis 5, wobei der Katalysator zum Ausbilden der Katalysatordünnfilmschicht (5) der Gegenelektrode (30) Platin, Nickel oder ein elektrisch leitendes Polymer ist.

7. Farbstoffsensibilisierte Solarzelle (1) gemäß Anspruch 6, wobei der Katalysator Platin oder Nickel ist, und die Dicke der Katalysatordünnfilmschicht (5) 0,5 bis 5 nm beträgt.

8. Farbstoffsensibilisierte Solarzelle (1) gemäß Anspruch 6, wobei der Katalysator ein elektrisch leitendes Polymer ist, und die Dicke der Katalysatordünnfilmschicht (5) 1 bis 10 nm beträgt.

9. Verfahren zur Herstellung einer farbstoffsensibilisierten Solarzelle (1) gemäß einem der Ansprüche 1 bis 8, das Folgendes aufweist:

einen Schritt des Ätzens einer rostfreien Stahlplatte (4; 50) in einer wässrigen Lösung mit darin existierenden Ferritionen, um grübchenartige Vertiefungen (60) in der Platte zu bilden, wodurch dem Substrat eine aufgeraute Oberfläche mit einer arithmetischen, mittleren Rauhigkeit Ra von zumindest 0,2 μm gegeben wird,

einen Schritt des Formens auf der aufgerauten Oberfläche eines Beschichtungsfilms, der Oxidhalbleiterpartikel enthält,

einen Schritt des Beschießens des Beschichtungsfilms, um eine poröse Halbleiterschicht (6) zu bilden,

einen Schritt des Tauchens der Halbleiterschicht (6) in ein Lösungsmittel mit einem darin dispergierten Sensibilisierungsfarbstoff (8), um zu bewirken, dass die Halbleiterschicht (6) den Sensibilisierungsfarbstoff (8) trägt, wodurch eine Photoelektrode (40) erhalten wird, die die Sensibilisierungsfarbstoff tragende Halbleiterschicht (6) auf der aufgerauten Oberfläche der Substratplatte (4; 50) aus rostfreiem Stahl aufweist, und

einen Schritt des Anordnens der Photoelektrode (40) und der für sichtbares Licht durchlässigen Gegenelektrode (30) mit der auf der Oberfläche des lichtdurchlässigen, elektrisch leitenden Materials geformten Katalysatordünnfilmschicht (5) in einer solchen Art und Weise, dass die Halbleiterschicht (6) der Photoelektrode (40) zu der Katalysatordünnfilmschicht (5) der Gegenelektrode (30) weisen könnte, und

Einleiten einer elektrolytischen Lösung (9) in den Raum zwischen den beiden Elektroden (40, 30).

10. Verfahren zum Herstellen einer farbstoffsensibilisierten Solarzelle (1) gemäß Anspruch 9, wobei die wässrige Lösung mit einem darin existierenden Ferrition eine wässrige, ferritische, chloridenthaltende Lösung ist.

**Revendications**

1. Cellule solaire sensibilisée par un colorant (1) comprenant une photo-électrode (40) formée en utilisant une plaque d'acier inoxydable (4 ; 50) et une contre-électrode (30) formée en utilisant un matériau électro-conducteur photo-transmissif (3), dans laquelle :

la photo-électrode (40) comprend, en tant que substrat, une plaque d'acier inoxydable (4 ; 50) ayant une composition chimique correspondant à un acier inoxydable ferritique contenant au moins 16 % en poids de Cr et au moins 0,3 % en poids de Mo, et défini par la norme JIS G4305:2005, et comprend, formée sur la surface du substrat, une couche semi-conductrice portant un colorant de sensibilisation (6) ;

la contre-électrode (30) comporte une couche mince de catalyseur (5) formée sur la surface du matériau électro-conducteur photo-transmissif (3) et a une capacité de transmission de la lumière visible ; et

la couche semi-conductrice (6) de la photo-électrode (40) et la couche mince de catalyseur (5) de la contre-électrode (30) se font face par l'intermédiaire d'une solution électrolytique (9) ;

**caractérisée en ce que** la plaque d'acier inoxydable (4 ; 50) a une surface rugueuse dans laquelle des indentations en forme de pointes (60) sont formées et qui est contrôlée pour avoir une rugosité arithmétique moyenne Ra d'au moins 0,2 μm.

2. Cellule solaire sensibilisée par un colorant (1) selon la revendication 1, dans laquelle l'acier inoxydable utilisé pour la photo-électrode (40) a une composition chimique correspondant à un acier inoxydable austénitique contenant au moins 16 % en poids de Cr et au moins 0,3 % en poids de Mo et défini par la norme JIS G4305:2005.

**3.** Cellule solaire sensibilisée par un colorant (1) selon la revendication 1, dans laquelle l'acier inoxydable utilisé pour la photo-électrode (40) est un acier inoxydable ferritique comprenant, en poids, au plus 0,15 % de C, au plus 1,2 % de Si, au plus 1,2 % de Mn , au plus 0,04 % de P, au plus 0,03 % de S, au plus 0,6 % de Ni, de 16 à 32 % de Cr, de 0,3 à 3 % de Mo, de 0 à 1 % de Cu, de 0 à 1 % de Nb, de 0 à 1 % de Ti, de 0 à 0,2 % de Al, au plus 0,025 % de N, de 0 à 0,01 % de B, le reste en Fe et impuretés inévitables.

**4.** Cellule solaire sensibilisée par un colorant (1) selon la revendication 1, dans laquelle l'acier inoxydable utilisé pour la photo-électrode (40) est un acier inoxydable austénitique comprenant, en poids, au plus 0,15 % de C, au plus 4 % de Si, au plus 2,5 % de Mn, au plus 0,045 % de P, au plus 0,03 % de S, de 6 à 28 % de Ni, de 16 à 32 % de Cr, de 0,3 à 7 % de Mo, de 0 à 3,5 % de Cu, de 0 à 1 % de Nb, de 0 à 1 % de Ti, de 0 à 0,1 % de Al, au plus 0,3 % de N, de 0 à 0,01 % de B, le reste en Fe et impuretés inévitables.

**5.** Cellule solaire sensibilisée par un colorant (1) selon l'une quelconque des revendications 1 à 4, dans laquelle la contre-électrode (30) à une transmission en lumière visible tel que la transmission lumineuse pour une longueur d'onde de 500 nm est d'au moins 55 %.

**6.** Cellule solaire sensibilisée par un colorant (1) selon l'une quelconque des revendications 1 à 5, dans laquelle le catalyseur pour constituer la couche mince de catalyseur (5) de la contre-électrode (30) est du platine, du nickel ou un polymère électro-conducteur.

**7.** Cellule solaire sensibilisée par un colorant (1) selon la revendication 6, dans laquelle le catalyseur est du platine ou du nickel, et l'épaisseur de la couche mince de catalyseur (5) est comprise entre 0,5 et 5 nm.

**8.** Cellule solaire sensibilisée par un colorant (1) selon la revendication 6, dans laquelle le catalyseur est un polymère électro conducteur, et l'épaisseur de la couche mince de catalyseur (5) est comprise entre 1 et 10 nm.

**9.** Procédé de fabrication d'une cellule solaire sensibilisée par un colorant (1) selon l'une quelconque des revendications 1 à 8 comprenant :

une étape de gravure d'une plaque d'acier inoxydable (4 ; 50) dans une solution aqueuse avec un ion ferrique existant pour former des indentations en forme de pointes (60) dans la plaque, fournissant ainsi un substrat qui a une surface rugueuse avec une rugosité arithmétique moyenne Ra d'au moins 0,2 μm,
une étape de formation, sur la surface rugueuse, d'un film de revêtement qui contient des particules d'oxyde semiconducteur,
une étape de recuit du film de revêtement pour former une couche semi-conductrice poreuse (6),
une étape d'immersion de la couche semi-conductrice (6) dans un solvant avec un colorant de sensibilisation (8) qui est dispersé pour amener la couche semi-conductrice (6) à porter le colorant de sensibilisation (8), fournissant ainsi une photo-électrode (40) qui comprend la couche semi-conductrice (6) portant le colorant de sensibilisation sur la surface rugueuse de la plaque d'acier inoxydable de substrat (4 ; 50), et
une étape d'agencement de la photo-électrode (40) et de la contre-électrode (30) photo-transmissive dans le visible (30) avec la couche mince de catalyseur (5) formée sur la surface du matériau électro-conducteur photo-transmissif, de sorte que la couche semi-conductrice (6) de la photo-électrode (40) peut faire face à la couche mince de catalyseur (5) de la contre-électrode (30), et
introduire une solution électrolytique (9) dans l'espace entre les deux électrodes (40, 30).

**10.** Procédé de fabrication d'une cellule solaire sensibilisée par un colorant (1) selon la revendication 9, dans lequel la solution aqueuse avec un ion ferrique qui y est présent est une solution aqueuse contenant un chlorure ferrique.

Fig.1

Fig.2

Fig.3

Fig.4

Fig.5

Fig.6

**EP 2 469 641 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 200834110 A

- JP 2009026532 A